# EUROPÄISCHE PATENTSCHRIFT

(11) **EP 3 524 985 B1**
(45) Veröffentlichungstag und Bekanntmachung des Hinweises auf die Patenterteilung: **13.01.2021**
(21) Anmeldenummer: 19152932.0
(22) Anmeldetag: 22.01.2019
(51) Int. Cl.: G01R 27/02, G01R 31/52, G01R 31/12

(54) **VORRICHTUNG UND VERFAHREN FÜR EINE ISOLATIONSÜBERWACHUNG MIT ERKENNUNG EINES FEHLERBEHAFTETEN AUSSENLEITERS IN EINEM 3-PHASIGEN UNGEERDETEN STROMVERSORGUNGSSYSTEM**
APPARATUS AND METHOD FOR INSULATION MONITORING WITH DETECTION OF DEFECTIVE OUTER CONDUCTOR IN AN UNEARTHED 3-PHASE POWER SUPPLY SYSTEM
DISPOSITIF ET PROCÉDÉ POUR UNE SURVEILLANCE DE L'ISOLATION À RECONNAISSANCE D'UN CONDUCTEUR EXTÉRIEUR DÉFECTUEUX DANS UN SYSTÈME D'ALIMENTATION ÉLECTRIQUE TRIPHASÉ ISOLÉ TERRE

(30) Priorität: 09.02.2018 DE 102018102959
(43) Veröffentlichungstag der Anmeldung: 14.08.2019
(73) Patentinhaber: Bender GmbH & Co. KG, 35305 Grünberg (DE)
(72) Erfinder: GEIß, Manfred, 35327 Ulrichstein (DE); WEIß, Carsten, 35321 Laubach (DE)
(74) Vertreter: advotec.

(56) Entgegenhaltungen:
- CN-B- 101 915 884
- DE-A1- 19 837 933
- ES-T3- 2 319 897
- US-A1- 2015 255 976
- US-A1- 2016 315 461

## Beschreibung

Die Erfindung betrifft eine Vorrichtung und ein Verfahren für eine Isolationsüberwachung mit Erkennung eines fehlerbehafteten Außenleiters in einem 3-phasigen ungeerdeten Stromversorgungssystem, mit einer ersten Ankopplungsschaltung zum Verbinden von einem der Außenleiter, mit einem Pulsgenerator zur Erzeugung eines Messstroms, mit einer ersten Messeinrichtung zur Messung eines durch den Messstrom bewirkten Messspannungsabfalls und mit einer Auswerteeinrichtung zur Bestimmung eines Isolationswiderstands.

Elektrische Anlagen, mit hohem Leistungsbedarf, wie zum Beispiel Schmelzöfen, Temperöfen, sonstige Erwärmungsvorrichtungen oder Abscheideanlagen der chemischen Industrie benötigen oftmals besondere Schutzmaßnahmen zur Begrenzung der Auswirkungen elektrischer Fehler. Begründet ist dies durch die Notwendigkeit, Brände, Explosionen oder chemische Störfälle zu verhindern. Weiterhin besteht oftmals die Notwendigkeit, elektrische Anlagen bei Auftreten eines elektrischen Fehlers über einen gewissen Zeitraum noch weiter betreiben zu können, um einen Produktionsausfall zu vermeiden oder weil ein Produktionsprozess aus betrieblichen oder physikalischen Gründen nicht kurzfristig unterbrechbar ist.

Idealerweise werden diese Ziele durch Verwendung eines ungeerdeten Stromversorgungssystems zur Stromversorgung erreicht, welches auch als isoliertes Stromversorgungssystem oder kurz als IT-System bezeichnet (frz. Isolé Terre - IT) wird.

Bei dieser Netzform weist die Sekundärseite des einspeisenden Netztransformators oder der stromerzeugende Generator keine direkte Verbindung zum Erdpotential - zu Erde - auf. Tritt in der mit der Einspeisestelle verbundenen elektrischen Anlage ein erster Isolationsfehler wie beispielsweise ein Erdschluss in einem angeschlossenen Verbraucher oder an einem Außenleiter selbst auf, so fließt zunächst kein kritischer Fehlerstrom und die Anlage kann meist weiter betrieben werden - zumindest kommt es nicht zu hochenergetischen Fehlersituationen. Da durch den ersten Fehler nunmehr ein geerdetes Netz entstanden ist, hätte ein zweiter Isolationsfehler die gleiche folgenschwere Auswirkung wie in einem geerdeten Stromversorgungssystem (TN-System - frz. terre neutre). Es ist daher erforderlich, den ersten Fehler sofort zu erkennen und diesen, abhängig von der individuellen Gefährdungsbeurteilung der Anlage, zeitnah zu beseitigen oder gar den betroffenen Anlagenteil sofort abzuschalten.

Isolationsüberwachungsvorrichtungen für isolierte Stromversorgungssysteme sind zum Beispiel in ES 2 319 897 T3, CN 101 915 884 B, US 2016/315461 A1, US 2015/255976 A1 und in DE 198 37 933 A1 offenbart.

Zur Überwachung des Isolationszustandes der Anlage werden üblicherweise Isolationsüberwachungsgeräte eingesetzt, die einen Pulsgenerator in Funktion eines Messspannungsgenerators aufweisen, der dem Netz eine Messspannung überlagert. Bei Auftreten eines Isolationsfehlers schließt sich zwischen einem fehlerbehafteten Außenleiter und Erde ein Messkreis, in dem ein dem Isolationsfehler proportionaler Messstrom fließt, der mittels einer Messeinrichtung des Isolationsüberwachungsgerätes als Messspannungsabfall erfasst und in einer (Isolationswiderstands-)Auswerteeinrichtung des Isolationsüberwachungsgerätes ausgewertet wird, um den Isolationswiderstand zu bestimmen.

Da bei elektrischen Anlagen mit hohem Leistungsbedarf zur Verringerung der Betriebsströme und damit auch der verwendeten Leiterquerschnitte oftmals hohe Betriebsspannungen angewandt werden, sind für diese Betriebsspannungen ausgelegte Isolationsüberwachungseinrichtungen teuer, beziehungsweise benötigen aufwändige Ankoppelgeräte.

Als weiterer Nachteil ist es aufgrund der in den Isolationsüberwachungsgeräten angewendeten Messverfahren lediglich möglich, nur ein einziges (aktives) Isolationsüberwachungsgerät pro IT-System einzusetzen, um eine gegenseitige Beeinflussung der Messvorgänge zu vermeiden. Dieses Isolationsüberwachungsgerät überwacht dann den Gesamtisolationswiderstand der Anlage.

Zur vorausschauenden Planung von Wartungsmaßnahmen, zur Durchführung von Reparaturarbeiten aufgrund von Isolationsverschlechterungen oder zum selektiven Abschalten von Anlagenteilen - was einen Weiterbetrieb der restlichen Anlage ermöglicht - ist es erforderlich, den Ort des aufgetretenen Isolationsfehlers in der Anlage bestimmen zu können.

Hierfür wird dem Stand der Technik gemäß eine Isolationsfehlersucheinrichtung verwendet. Diese umfasst einen Prüfstromgenerator zur Erzeugung eines Prüfstroms und eine (Prüfstrom-)Auswerteeinrichtung mit daran angeschlossenen Messstromwandlern, um den fehlerbehafteten Leitungsabgang zu lokalisieren.

Ist in dem ungeerdeten Stromversorgungssystem ein erster Isolationsfehler von dem Isolationsüberwachungsgerät erkannt worden, startet die Isolationsfehlersuche, indem der Prüfstromgenerator einen Prüfstrom erzeugt, der an zentraler Stelle in das ungeerdete Stromversorgungssystem zwischen einem oder mehreren aktiven Leitern und Erde einspeist wird. Es entsteht ein geschlossener Stromkreis, in dem der Prüfstrom von dem Prüfstromgenerator über den oder die spannungsführenden aktiven Leiter, den Isolationsfehler und über eine Erdverbindung zurück zu dem Prüfstromgenerator fließt.

Die Lokalisierung des Fehlerortes erfolgt über eine Detektion des Prüfstroms durch die Messstromwandler, wobei jedem zu überwachenden Leitungsabschnitt ein Messstromwandler fest zugeordnet ist.

Der Prüfstrom wird dabei von allen Messstromwandlern, die in dem Prüfstromkreis (Fehlerstromkreis) liegen, als Differenzstrom erfasst, in der Auswerteeinrichtung ausgewertet und von dem Isolationsfehlersuchgerät angezeigt. Durch die bekannte Zuordnung der Messstromwandler zu den Leitungszweigen kann der Fehlerort lokalisiert werden.

Bei der zuvor beschriebenen Verwendung hoher Netzspannungen in Stromversorgungssystemen, die Verbraucher mit einem hohen Leistungsbedarf versorgen, sind jedoch geeignete Prüfstromgeneratoren auf dem Markt nur sehr schwer verfügbar, beziehungsweise es ist aufwändig, einen für derartig hohe Betriebsspannungen ausgelegten Prüfstromgenerator zu konstruieren, da entsprechende spannungsresistente Bauteile sehr teuer sind.

Weiterhin stellt die Isolationsfestigkeit der Komponenten der Isolationsfehlersucheinrichtung, insbesondere der Messstromwandler, oftmals ein Problem dar, welches einer Isolationsfehlersuche entgegenstehen kann. Die Nachrüstung von bestehenden Anlagen kann ebenfalls schwierig sein, da der Bauraum für entsprechende, nachträglich einbaubare sogenannte "teilbare" Stromwandler, meist nicht zur Verfügung steht. Der Einsatz von Bandwandlern ist aufgrund der eingeschränkten Genauigkeit und Empfindlichkeit oft ebenfalls nicht wünschenswert. Zudem arbeiten konventionelle Isolationsfehlersuchsysteme eher langsam. Bis zur Fehlerlokalisierung können mehr als 10 Sekunden vergehen, was weit oberhalb der Anforderungen für die oben genannten Applikationen liegt.

Insbesondere in 3-phasigen IT-Systemen, in denen unabhängig voneinander an jeder Phase, d. h. an jedem Außenleiter jeweils nur ein von den anderen Außenleitern unabhängiger einphasiger Verbraucher mit hohem Leistungsbedarf angeschlossen ist, ist es wünschenswert, im (ersten) Fehlerfall selektiv nur den fehlerbehafteten, von dem Fehler betroffenen, Außenleiter des 3-phasigen IT-Systems zu identifizieren und diesen gegebenenfalls vom Netz zu trennen, aber die übrigen Verbraucher über die nicht fehlerbehafteten Außenleiter weiter zu versorgen.

Vorliegend wird davon ausgegangen, dass die an die jeweilige Phase angeschlossenen Verbraucher hinsichtlich ihres Ersatzschaltbildes mit weitgehend identischen Werten modelliert werden können. Z.B. ist eine rein kapazitive Last an einem Außenleiter und eine rein induktive Last an einem anderen Außenleiter im Rahmen der Erfindung nicht zulässig, da diese Konstellation den Phasenwinkel stark beeinflussen würde.

Der vorliegenden Erfindung liegt somit die Aufgabe zugrunde, eine Vorrichtung zu konstruieren und ein Verfahren anzugeben, welche eine Isolationsüberwachung und eine schnelle Erkennung eines fehlerbehafteten Außenleiters in einem 3-phasigen ungeerdeten Stromversorgungssystem ermöglichen, an dessen Außenleiter jeweils gleichartige Verbraucher angeschlossen sind.

Diese Aufgabe wird bezogen auf eine Vorrichtung in Verbindung mit dem Oberbegriff des Anspruchs 1 dadurch gelöst, dass die erste Messeinrichtung für eine Messung einer Netzspannung zwischen dem verbundenen Außenleiter und Erde ausgeführt ist sowie durch eine zweite Ankopplungsschaltung zum Verbinden eines Sternpunktes und durch eine zweite Messeinrichtung zur Messung einer Sternpunktspannung zwischen dem Sternpunkt und Erde sowie dadurch, dass die Auswerteeinrichtung für eine Auswertung einer Phasenlage zwischen der Netzspannung und der Sternpunktspannung ausgeführt ist, um einen fehlerbehafteten Außenleiter zu ermitteln.

Der Grundgedanke der vorliegenden Erfindung beruht darauf, ausgehend von nur einer Messung der Netzspannung gegen Erde an einem der Außenleiter und einer Messung der Sternpunktspannung gegen Erde den Phasenwinkel zwischen der gemessenen Netzspannung und der gemessenen Sternpunktspannung zu bestimmen. Der Wert des so bestimmten Phasenwinkels liegt in einem von drei Winkelbereichen, die jeweils einem der drei Außenleiter zuzuordnen sind, sodass der fehlerbehaftete Außenleiter bestimmt ist. Beispielsweise erstrecken sich im Falle rein ohmscher Verbraucher und näherungsweise gleichen Ableitkapazitäten der Außenleiter die Winkelbereiche über jeweils 120 Grad, sodass keine nicht zuordenbare Bereiche verbleiben.

Grundsätzlich sind die jedem einzelnen Außenleiter zugeordneten Winkelbereiche applikationsspezifisch einstellbar. Das ermöglicht einerseits die Anpassung an individuelle Phasenwinkel der Verbraucher und andererseits die Definition von Bereichen, die nicht einem einzelnen Außenleiter (einer einzelnen Phase) zugeordnet sein sollen (z. B. bei Isolationsfehlern an zwei Außenleitern). In letzterem Fall führt das zur Abschaltung der gesamten Anlage, weil die Zuordnung des fehlerbehafteten Außenleiters nicht möglich ist.

Die Ermittlung des fehlerbehafteten Außenleiters erfolgt somit durch Messung von nur einer Netzspannung in Verbindung mit der Messung der Sternpunktspannung durch Auswertung der Phasenlage zwischen beiden gemessenen Spannungen.

In Erweiterung der aus dem Stand der Technik bekannten Messung eines durch den Messstrom bewirkten Messspannungsabfalls ist die erste Messeinrichtung daher erfindungsgemäß so ausgeführt, dass mit ihr die Messung der Netzspannung zwischen dem Außenleiter und Erde vorgenommen werden kann.

Über eine zweite Ankopplungsschaltung wird in Verbindung mit einer zweiten Messeinrichtung erfindungsgemäß die Sternpunktspannung zwischen dem Sternpunkt und Erde gemessen.

Die Auswerteeinrichtung ist so ausgeführt, dass neben der Bestimmung des Isolationswiderstands auch die Phasenlage zwischen der von der ersten Messeinrichtung gemessenen Netzspannung und der von der zweiten Messeinrichtung gemessenen Sternpunktspannung bestimmt wird. Die so ermittelte Phasenlage liefert eine Aussage darüber, welcher der Außenleiter in dem 3-phasigen ungeerdeten Stromversorgungssystem fehlerbehaftet ist.

Die erfindungsgemäße, zweiseitige Ankopplung mit der ersten und der zweiten Ankopplungsschaltung ermöglicht in Verbindung mit der Auswertung der Phasenlagen der gemessenen Netzspannung und der gemessenen Sternpunktspannung den fehlerbehafteten Außenleiter zu erkennen. Die in dieser Weise erfindungsgemäß ausgestattete Vorrichtung kann als ein erweitertes Isolationsüberwachungsgerät aufgefasst werden, welches über die Überwachung des Isolationswiderstands hinaus die Möglichkeit der Erkennung eines fehlerbehafteten Außenleiters bietet.

In weiterer Ausgestaltung weist die Auswerteeinrichtung einen Entscheider auf, um die ermittelte Phasenlage einem Außenleiter zuzuordnen.

Der Entscheider führt eine Zuordnung zwischen der ermittelten Phasenlage und einem der drei Außenleiter durch, indem geprüft wird, in welchem der drei gleichgroßen und jeweils einem der Außenleiter zugeordneten Winkelbereiche der ermittelte Phasenwert liegt.

Weiterhin weist die erfindungsgemäße Vorrichtung einen Steuerausgang zur Ansteuerung einer Trennvorrichtung für mindestens einen Außenleiter auf.

Um nach Erkennung des fehlerbehafteten Außenleiters den an diesen Außenleiter angeschlossenen Verbraucher vom dem Stromversorgungsnetz trennen zu können, ist zur Ansteuerung der Trennvorrichtung ein Steuerausgang vorgesehen. Der Steuerausgang führt ein Steuersignal entsprechend des in der Auswerteeinrichtung erzielten Zuordnungsergebnisses.

Die der Erfindung zugrundeliegende Aufgabe wird bezogen auf ein Verfahren in Verbindung mit dem Oberbegriff des Anspruchs 4 gelöst durch Messen einer Netzspannung zwischen dem verbundenen Außenleiter und Erde mittels der ersten Messeinrichtung, Verbinden eines Sternpunktes mit einer zweiten Ankopplungsschaltung, Messen einer Sternpunktspannung zwischen dem Sternpunkt und Erde mittels einer zweiten Messeinrichtung und Auswerten einer Phasenlage zwischen der Netzspannung und der Sternpunktspannung mittels der Auswerteeinrichtung.

Erfindungsgemäß erfolgt eine Messung der Netzspannung zwischen dem Außenleiter und Erde mittels der ersten Messeinrichtung. Über die zweite Ankopplungsschaltung wird weiterhin der Sternpunkt des 3-phasigen ungeerdeten Stromversorgungssystems angeschlossen, um zusätzlich die Sternpunktspannung zwischen dem Sternpunkt und Erde mittels der zweiten Messeinrichtung messen zu können. In der Auswerteeinrichtung erfolgt über das Bestimmen des Isolationswiderstands hinaus das Auswerten der Phasenlage zwischen der Netzspannung und der Sternpunktspannung. Das Auswerten der Phasenlage erfolgt durch Entscheiden in welchem der jeweils einem Außenleiter zugeordneten Winkelbereiche der ermittelte Wert der Phasenlage liegt.

Somit kann aus der Phasenlage unmittelbar auf den fehlerbehafteten Außenleiter in dem 3-phasigen ungeerdeten Stromversorgungssystem geschlossen werden.

In weiterer Ausgestaltung des Verfahrens erfolgt das Auswerten der Phasenlage zwischen der Netzspannung und der Sternpunktspannung durch Messen einer Periodendauer der Netzspannung, Ermitteln einer Phasenverschiebungszeit zwischen der Netzspannung und der Sternpunktspannung und Umrechnen der Phasenverschiebungszeit in die Phasenlage mit Zuordnen des fehlerbehafteten Außenleiters.

Zunächst wird die Periodendauer der Netzspannung ermittelt. Dies kann durch Detektieren der Nulldurchgänge des Netzspannungsverlaufs und einer Abstandsbestimmung der Nulldurchgänge erfolgen. In Verbindung mit der Messung der Sternpunktspannung wird dann eine Phasenverschiebungszeit zwischen der Netzspannung und der Sternpunktspannung ermittelt. Anschließend wird diese Phasenverschiebungszeit unter Berücksichtigung der Periodendauer in die Phasenlage umgerechnet. Die Zuordnung der Phasenlage zu dem fehlerbehafteten Außenleiter ergibt sich exemplarisch für rein ohmsche Verbraucher und näherungsweise gleichen Ableitkapazitäten der Außenleiter dabei wie folgt: Außenleiter L1 ist fehlerbehaftet, falls der Phasenwinkel größer 300 Grad und kleiner/gleich 60 Grad ist, Außenleiter L2 ist fehlerbehaftet, falls der Phasenwinkel größer 60 Grad und kleiner/gleich 180 Grad ist und Außenleiter L3 ist fehlerbehaftet, falls der Phasenwinkel größer 180 Grad und kleiner/gleich 300 Grad ist.

Weiterhin wird ein Steuersignal zum Trennen des fehlerbehafteten Außenleiters erzeugt.

Ist ein fehlerbehafteter Außenleiter erkannt, so wird über einen Steuerausgang eine in dem Stromversorgungssystem vorhandene Trennvorrichtung angesteuert, welche den gemäß der Zuordnung zwischen Phasenlage und Außenleiter als fehlerbehaftet erkannten Außenleiter und damit die Last von dem Stromversorgungssystem trennt.

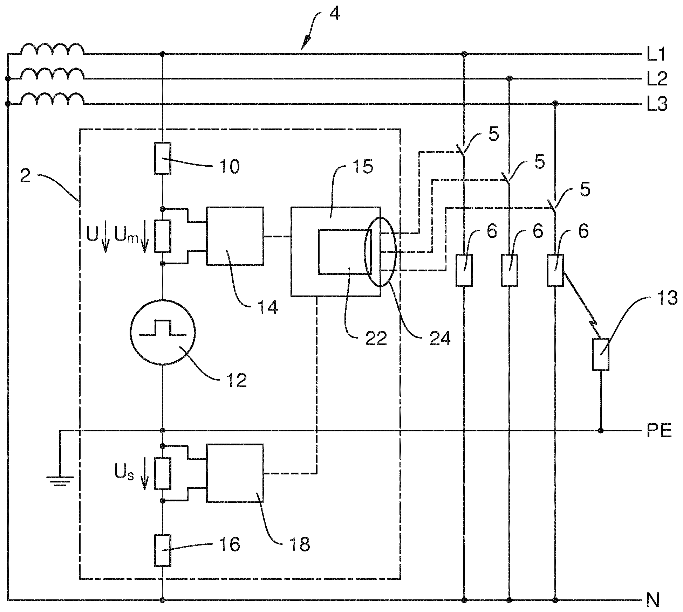

Weitere vorteilhafte Ausgestaltungsmerkmale ergeben sich aus der nachfolgenden Beschreibung und der Zeichnung, die eine bevorzugte Ausführungsform der Erfindung an Hand eines Beispiels erläutert. Es zeigt die
- **Fig.:**: eine erfindungsgemäße Vorrichtung für eine Isolationsüberwachung mit Erkennung eines fehlerbehafteten Außenleiters in einem 3-phasigen ungeerdeten Stromversorgungssystem.

In der **Fig.** ist eine erfindungsgemäße Vorrichtung 2 in einem 3-phasigen ungeerdeten Stromversorgungssystem 4 dargestellt, welches die Außenleiter L1, L2 und L3 umfasst, an die jeweils ein Verbraucher 6 angeschlossen ist. An dem an den Außenleiter L3 angeschlossenen Verbraucher 6 liegt ein Isolationsfehler 13 in Form eines Erdschlusses vor.

Das ungeerdete Stromversorgungssystem 4 ist mit einer Trennvorrichtung 5 versehen, welche jeden der Außenleiter L1, L2, L3 separat abschalten kann.

Die erfindungsgemäße Vorrichtung 2 umfasst eine erste Ankopplungsschaltung 10 zum Verbinden des Außenleiters L1, einen Pulsgenerator 12 zur Erzeugung eines Messstroms, eine erste Messeinrichtung 14 zur Messung eines durch den Messstrom bewirkten Messspannungsabfalls Um und eine Auswerteeinrichtung 15 zur Bestimmung eines Isolationswiderstands.

Die erste Ankopplungsschaltung 10 kann hochohmig ausgeführt sein, sodass dort vorteilhafterweise keine großen Leistungen mit hoher Wärmeentwicklung abgeführt werden müssen. Zudem ist eine Verringerung der Spannungsfestigkeit durch Verwendung eines handelsüblichen Spannungswandlers oder durch Verwendung eines möglicherweise vorhandenen Niederspannungsabgriffs des IT-Systemtrafos möglich.

Die erste Messeinrichtung 14 erfasst über die erste Ankopplungsschaltung 10 neben dem durch den Messstrom bewirkten Messspannungsabfall Um erfindungsgemäß auch die Netzspannung U zwischen dem Außenleiter L1 und Erde PE.

Die erste Messeinrichtung 14 weist somit schaltungstechnische Bauelemente wie beispielsweise Operationsverstärker-Schaltungen auf, die für die Verarbeitung von Nennspannungen des ungeerdeten Stromversorgungssystems geeignet sind.

Weiterhin umfasst die erfindungsgemäße Vorrichtung 2 eine zweite Ankopplungsschaltung 16 zum Verbinden eines Sternpunktes N - oder eines mit dem Sternpunkt N verbundenen Neutralleiters - und eine zweite Messeinrichtung 18 zur Messung einer Sternpunktspannung Us zwischen dem Sternpunkt N und Erde PE.

Auch über die zweite Ankopplungsschaltung 16 an den Sternpunkt N bzw. den Neutralleiter muss im Normalbetrieb keine hohe Leistung abgeführt werden, da der Sternpunkt N im fehlerfreien Zustand annähernd Erdpotential aufweist. Aber auch im Fehlerfall kann die Leistungsabführung der zweiten Ankopplungsschaltung 16 als minimal betrachtet werden, wenn die Maßnahme der sofortigen Abschaltung des mit dem Fehler 13 behafteten Außenleiters L3 angewendet wird.

In der Auswerteeinrichtung 15 wird neben der Bestimmung des Isolationswiderstands die Phasenlage zwischen der Netzspannung U und der Sternpunktspannung Us ausgewertet, um über die Zuordnung zwischen Wert der Phasenlage und Außenleiter L1, L2, L3 den fehlerbehafteten Außenleiter L3 zu bestimmen.

Die Zuordnung zwischen dem Wert der Phasenlage und den Außenleitern L1, L2, L3 erfolgt in einem Entscheider 22 der Auswerteeinrichtung 15, die Ansteuerung der Trennvorrichtung 5 erfolgt über einen Steuerausgang 24 der Auswerteeinrichtung 15.

Für den Anwender des erfindungsgemäßen, erweiterten Isolationsüberwachungsgerätes ergibt sich der Vorteil, dass die Verbraucher (Produktionseinrichtungen) an den nicht von dem Isolationsfehler betroffenen Außenleitern (Phasen), vorliegend L1 und L2 weiter betrieben werden können und so der Produktionsausfall auf die abgeschaltete, fehlerbehaftete Produktionsanlage begrenzt bleibt.

## Patentansprüche

1. Vorrichtung für eine Isolationsüberwachung (2) mit Erkennung eines fehlerbehafteten Außenleiters (L1, L2, L3) in einem 3-phasigen ungeerdeten Stromversorgungssystem (4), mit einer ersten Ankopplungsschaltung (10) zum Verbinden von einem der Außenleiter (L1, L2, L3), mit einem Pulsgenerator (12) zur Erzeugung eines Messstroms, mit einer ersten Messeinrichtung (14) zur Messung eines durch den Messstrom bewirkten Messspannungsabfalls (Um) und mit einer Auswerteeinrichtung (15) zur Bestimmung eines Isolationswiderstands (Rf),
**dadurch gekennzeichnet,**
**dass** die erste Messeinrichtung (14) für eine Messung einer Netzspannung (U) zwischen dem verbundenen Außenleiter (L1, L2, L3) und Erde (PE) ausgeführt ist sowie durch eine zweite Ankopplungsschaltung (16) zum Verbinden eines Sternpunktes (N) und durch eine zweite Messeinrichtung (18) zur Messung einer Sternpunktspannung (Us) zwischen dem Sternpunkt (N) und Erde (PE) sowie dadurch, dass die Auswerteeinrichtung (15) für eine Auswertung einer Phasenlage zwischen der Netzspannung (U) und der Sternpunktspannung (Us) ausgeführt ist, um einen fehlerbehafteten Außenleiter (L1, L2, L3) zu ermitteln.

2. Vorrichtung nach Anspruch 1,
**dadurch gekennzeichnet,**
**dass** die Auswerteeinrichtung (15) einen Entscheider (22) aufweist, um die ermittelte Phasenlage einem Außenleiter (L1, L2, L3) zuzuordnen.

3. Vorrichtung nach Anspruch 1 oder 2,
**gekennzeichnet durch**
einen Steuerausgang (24) zur Ansteuerung einer Trennvorrichtung für mindestens einen Außenleiter (L1, L2, L3).

4. Verfahren zur Isolationsüberwachung mit Erkennung eines fehlerbehafteten Außenleiters (L1, L2, L3) in 3-phasigen ungeerdeten Stromversorgungssystemen, umfassend die Verfahrensschritte:
- Verbinden eines Außenleiters (L1, L2, L3) mit einer ersten Ankopplungsschaltung (10),
- Erzeugen eines Messstroms mittels eine Pulsgenerators (12),
- Messen einer durch den Messstrom bewirkten Messspannung mittels einer ersten Messeinrichtung (14),
- Bestimmen eines Isolationswiderstands mittels einer Auswerteeinrichtung (15),
**gekennzeichnet durch**
- Messen einer Netzspannung (U) zwischen dem verbundenen Außenleiter (L1, L2, L3) und Erde (PE) mittels der ersten Messeinrichtung (14),
- Verbinden eines Sternpunktes (N) mit einer zweiten Ankopplungsschaltung (16),
- Messen einer Sternpunktspannung (Us) zwischen dem Sternpunkt (N) und Erde (PE) mittels einer zweiten Messeinrichtung (18) und
- Auswerten einer Phasenlage zwischen der Netzspannung (U) und der Sternpunktspannung (Us) mittels der Auswerteeinrichtung (15).

5. Verfahren nach Anspruch 4,
**dadurch gekennzeichnet,**
**dass** das Auswerten der Phasenlage zwischen der Netzspannung (U) und der Sternpunktspannung (Us) erfolgt durch Messen einer Periodendauer der Netzspannung (U), Ermitteln einer Phasenverschiebungszeit zwischen der Netzspannung (U) und der Sternpunktspannung (Us) und Umrechnen der Phasenverschiebungszeit in die Phasenlage mit Zuordnen des fehlerbehafteten Außenleiters (L1, L2, L3).

6. Verfahren nach Anspruch 4 oder 5,
**dadurch gekennzeichnet,**
**dass** ein Steuersignal zum Trennen des fehlerbehafteten Außenleiters (L1, L2, L3) erzeugt wird.

## Claims

1. A device for insulation monitoring (2) including identification of a faulty outer conductor (L1, L2, L3) in a three-phase ungrounded power supply system (4), comprising a first coupling circuit (10) for connecting one of the outer conductors (L1, L2, L3), comprising a pulse generator (12) for generating a measuring current, comprising a first measuring device (14) for measuring a measuring-voltage drop (Um) effected by the measuring current, and comprising an evaluation device (15) for determining an insulation resistance (Rf),
**characterized in that**
the first measuring device (14) is configured for measuring a mains voltage (U) between the connected outer conductor (L1, L2, L3) and ground (PE) and **characterized by** a second coupling circuit (16) for connecting a neutral point (N) and by a second measuring device (18) for measuring a neutral-point voltage (Us) between the neutral point (N) and ground (PE) and **characterized in that** the evaluation device (15) is configured for evaluating a phase between the mains voltage (U) and the neutral-point voltage (Us) for detecting a faulty outer conductor (L1, L2, L3).

2. The device according to claim 1,
**characterized in that**
the evaluation device (15) comprises an decider (22) for assigning the determined phase to an outer conductor (L1, L2, L3).

3. The device according to claim 1 or 2,
**characterized by**
a control output (24) for controlling a disconnect device for at least one outer conductor (L1, L2, L3).

4. A method for insulation monitoring including identification of a faulty outer conductor (L1, L2, L3) in three-phase ungrounded power supply systems, having the method steps:
- connecting an outer conductor (L1, L2, L3) to a first coupling circuit (10),
- generating a measuring current by means of a pulse generator (12),
- measuring a measuring voltage, which is effected by the measuring current, by means of a first measuring device (14),
- determining an insulation resistance by means of an evaluation device (15),
**characterized by**
- measuring a mains voltage (U) between the connected outer conductor (L1, L2, L3) and ground (PE) by means of the first measuring device (14),
- connecting a neutral point (N) to a second coupling circuit (16),
- measuring a neutral-point voltage (Us) between the neutral point (N) and ground (PE) by means of a second measuring device (18), and
- evaluating a phase between the mains voltage (U) and the neutral point voltage (Us) by means of the evaluation device (15).

5. The method according to claim 4,
**characterized in that**
the phase between the mains voltage (U) and the neutral-point voltage (Us) is evaluated by measuring a period duration of the mains voltage (U), by determining a phase shift time between the mains voltage (U) and the neutral-point voltage (Us) and by converting the phase shift time to the phase including assigning the faulty outer conductor (L1, L2, L3).

6. The method according to claim 4 or 5,
**characterized in that**
a control signal for disconnecting the faulty outer conductor (L1, L2, L3) is generated.

## Revendications

1. Dispositif pour la surveillance d'isolement (2) incluant l'identification d'un conducteur de ligne (L1, L2, L3) erroné dans un système d'alimentation en courant (4) triphasé non mis à la terre, le dispositif comprenant un premier circuit de couplage (10) servant à connecter un des conducteurs de ligne (L1, L2, L3), comprenant un générateur d'impulsions (12) servant à générer un courant de mesure, comprenant un premier dispositif de mesure (14) servant à mesurer une chute de tension mesurée (Um) causée par le courant de mesure et comprenant un dispositif d'évaluation (15) servant à déterminer une résistance d'isolement (Rf),
**caractérisé en ce que**
le premier dispositif de mesure (14) est configuré pour mesurer une tension d'alimentation (U) entre le conducteur de ligne (L1, L2, L3) connecté et la terre (PE) et **caractérisé par** un deuxième circuit de couplage (16) servant à connecter un point neutre (N) et **caractérisé par** un deuxième dispositif de mesure (18) servant à mesurer une tension de point neutre (Us) entre le point neutre (N) et la terre (PE) et **caractérisé en ce que** le dispositif d'évaluation (15) est configuré pour évaluer une phase entre la tension d'alimentation (U) et la tension de point neutre (Us) pour détecter un conducteur de ligne (L1, L2, L3) erroné.

2. Dispositif selon la revendication 1,
**caractérisé en ce que**
le dispositif d'évaluation (15) comprend un décideur (22) pour associer la phase déterminée à un conducteur de ligne (L1, L2, L3).

3. Dispositif selon la revendication 1 ou 2,
**caractérisé par**
une sortie de commande (24) servant à commander un dispositif de coupage pour au moins un conducteur de ligne (L1, L2, L3).

4. Procédé pour la surveillance d'isolement incluant l'identification d'un conducteur de ligne (L1, L2, L3) erroné dans des systèmes d'alimentation en courant triphasés non mis à la terre, ayant les étapes de procédé suivantes :
- connecter un conducteur de ligne (L1, L2, L3) à un premier circuit de couplage (10),
- générer un courant de mesure au moyen d'un générateur d'impulsions (12),
- mesurer une tension de mesure, qui est causée par le courant de mesure, au moyen d'un premier dispositif de mesure (14),
- déterminer une résistance d'isolement au moyen d'un dispositif d'évaluation (15),
**caractérisé par**
- mesurer une tension d'alimentation (U) entre le conducteur de ligne (L1, L2, L3) connecté et la terre (PE) au moyen d'un premier dispositif de mesure (14),
- connecter un point neutre (N) à un deuxième circuit de couplage (16),
- mesurer une tension de point neutre (Us) entre le point neutre (N) et la terre (PE) au moyen d'un deuxième dispositif de mesure (18), et
- évaluer une phase entre la tension d'alimentation (U) et la tension de point neutre (Us) au moyen du dispositif d'évaluation (15).

5. Procédé selon la revendication 4,
**caractérisé en ce que**
la phase entre la tension d'alimentation (U) et la tension de point neutre (Us) est évaluée en mesurant une durée des impulsions de la tension d'alimentation (U), en déterminant un temps de décalage de phase entre la tension d'alimentation (U) et la tension de point neutre (Us) et en convertant le temps de décalage de phase en phase incluant associant le conducteur de ligne (L1, L2, L3) erroné.

6. Procédé selon la revendication 4 ou 5,
**caractérisé en ce**
**qu'**un signal de commande servant à découper le conducteur de ligne (L1, L2, L3) erroné est généré.
